## Europäisches Patentamt
## European Patent Office
## Office européen des brevets

(19)

(11) Numéro de publication: **0 156 708**
**B1**

(12) # FASCICULE DE BREVET EUROPÉEN

(45) Date de publication du fascicule du brevet:
03.02.88

(51) Int. Cl.⁴: **H 03 B 5/18**

(21) Numéro de dépôt: **85400423.1**

(22) Date de dépôt: **05.03.85**

(54) **Oscillateur hyperfréquences à transistor, commandé par capacité variable.**

(30) Priorité: **09.03.84 FR 8403638**

(43) Date de publication de la demande:
**02.10.85 Bulletin 85/40**

(45) Mention de la délivrance du brevet:
**03.02.88 Bulletin 88/5**

(84) Etats contractants désignés:
**DE GB IT NL**

(56) Documents cité:
**FR-A-2 343 361**

**IEEE TRANSACTIONS ON MICROWAVE THEORY AND TECHNIQUES, volume MTT-30, no. 12, décembre 1982, pages 2172-2177, IEEE, New York, US; B.N. SCOTT et al.: "Monolithic voltage controlled oscillator for X- and Ku-bands"**
**IEEE TRANSACTIONS ON ELECTRON DEVICES, volume ED-28, no. 2, février 1981, pages 158-162, IEEE, New York, US; J.S. JOSHI et al.: "Monolithic microwave gallium arsenide FET oscillators"**
**CONFERENCE PROCEEDINGS OF THE 9th EUROPEAN MICROWAVE CONFERENCE, 17-20 septembre 1979, Brighton, GB, pages 621-625, Microwave Exhibitions and Publishers Ltd., Sevenoaks, GB; P.G. MARECHAL et al.: "1.5 to 4.5 GHz varactor-tuned transistor oscillator"**

(73) Titulaire: **THOMSON- CSF, 173, Boulevard Haussmann, F-75379 Paris Cédex 08 (FR)**

(72) Inventeur: **Derewonko, Henri, THOMSON- CSF SCPI 173, bld Haussmann, F-75379 Paris Cedex 08 (FR)**
Inventeur: **Bessonneau, Guy, THOMSON- CSF SCPI 173, bld Haussmann, F-75379 Paris Cedex 08 (FR)**
Inventeur: **Camiade, Marc, THOMSON- CSF SCPI 173, bld Haussmann, F-75379 Paris Cedex 08 (FR)**
Inventeur: **Bert, Alain, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présénte invention concerne la structure de réalisation d'un oscillateur à transistor à effet de champ, commandé en fréquence par une tension continue. L'invention s'applique à tous les types d'oscillateurs basés sur un transistor à effet de champ, mais elle est plus particulièrement avantageuse dans les hyperfréquences, en bande X par exemple, domaine dans lequel sont utilisés des transistors en GaAs ou plus généralement en matériaux de type III-V. En effet, à ces fréquences, la longueur des connexions entre composants de l'oscillateur intervient grandement pour modifier la fréquence: la structure retenue pour l'oscillateur selon l'invention permet de stabiliser la puissance de sortie de l'oscillateur avec une bonne linéarité de fréquence, dans une bande de 1 GHz environ, ce qui constitue une bande étroite, mais cependant plus large que celle des oscillateurs à diodes par exemple.

Dans l'état actuel de la technologie, les oscillateurs travaillant en bande X, soit 5,2 à 11 GHz, sont réalisés en circuits hybrides, c'est-à-dire par l'association sur un substrat ou dans un boîtier de composants discrets, reliés entre eux par des métallisations sur le substrat ou des fils métalliques dans l'air. A ces fréquences, la longueur des fils n'est pas indifférente, et, par la self qu'ils présentent, elle peut modifier la fréquence de l'oscillateur.

En outre, les oscillateurs connus sont souvent basés sur une diode à effet Gunn et un varactor, c'est-à-dire une capacité variable de forte puissance, commandée par une tension. Ils présentent l'inconvénient d'avoir un mauvais rendement hyperfréquence, de l'ordre de 3 % seulement, et de n'être linéaires en fréquence, en fonction de la tension de commande, que dans une bande très étroite, de l'ordre de 300 MHz. Le manque de linéarité en sortie oblige, si une large bande est requise, à utiliser plusieurs oscillateurs en parallèle, et/ou des discriminateurs, lesquels provoquent des pertes d'insertion supplémentaires dans un dispositif dont le rendement n'est déjà pas élevé.

L'oscillateur selon l'invention utilise un transistor à effet de champ, commandé par un varicap, c'est-à-dire une capacité variable de faible puissance. Aux fréquences considérées, le transistor est préférentiellement réalisé en matériaux de type III-V, tel que GaAs, et le varicap est hyperabrupt, en silicium ou GaAs. Le rendement hyperfréquence de cet oscillateur atteint 20 à 30 %, c'est-à-dire qu'il est 10 fois meilleur que celui d'un oscillateur à diode Gunn, et son circuit d'accord lui communique une bonne linéarité en fréquence et une stabilité en puissance dans une bande de 1 GHz environ.

Le problème des longueurs de connexions est résolu selon l'invention en disposant les pastilles du transistor, du varicap et d'au moins une capacité d'accord en un empilement, à l'intérieur d'un boîtier prévu pour un transistor. Les liaisons sont assurées par le contact direct entre les pastilles, ou, pour celles qui sont côte à côte, par des longueurs minimales de fils métalliques, notamment pour les entrée-sortie du boîtier. Une seconde capacité d'accord est disposée à l'intérieur du boîtier, à une distance variable telle que la longueur du fil de connexion permet de régler partiellement la fréquence de l'oscillateur. Celle-ci est commandée essentiellement par la tension de commande du varicap, qui sert également de tension de polarisation du transistor.

De façon plus précise, l'invention concerne un oscillateur hyperfréquence à transistor commandé par capacité variable de type varicap, comportant un transistor à effet de champ dont la grille est mise à la masse à travers une self, dont le drain constitue une sortie de l'oscillateur et dont la source est réunie à un circuit d'accord constitué par un varicap en parallèle avec une self d'accord, le circuit oscillant comportant en outre une première capacité connectée entre varicap et masse en vue d'isoler de la masse la tension de commande $V_p$ appliquée au varicap, et, connecté entre la self d'accord et la masse, un circuit d'autopolarisation formé par une résistance découplée par une seconde capacité, cet oscillateur étant caractérisé en ce que le transistor, le varicap et la première capacité sont intégrés dans un même boîtier hyperfréquence, sous forme d'un micromodule, la pastille du transistor et la pastille du varicap étant fixées côte à côte sur la pastille de la première capacité, ledit boîtier étant muni de deux connexions d'accès dont la première constitue la sortie de l'oscillateur et dont la deuxième est alimentée par une tension de commande $V_p$.

L'invention sera mieux comprise par la description d'une forme de réalisation d'oscillateur hyperfréquence, cette description s'appuyant sur les figures jointes en annexe, qui représentent:

- figure 1: circuit oscillant, à transistor à effet de champ, selon l'art connu,
- figure 2: circuit oscillant utilisé dans l'oscillateur selon l'invention,
- figure 3: schéma d'implantation des composants de l'oscillateur dans un boîtier, selon une première forme de l'invention,
- figure 4: schéma d'implantation des composants de l'oscillateur dans un boîtier, selon une variante de l'invention,
- figure 5: courbes caractéristiques de l'oscillateur selon l'invention: fréquence en fonction de la tension de commande, et puissance en fonction de la fréquence.

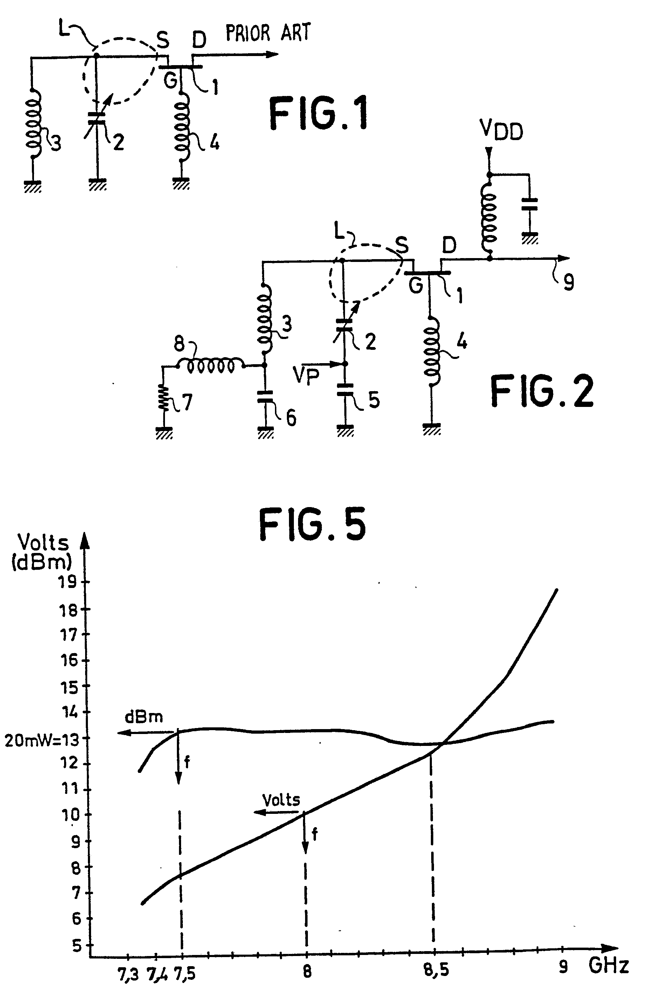

La figure 1 représente le schéma, connu, d'un oscillateur à transistor à effet de champ du type de ceux décrits par exemple dans les Conference Proceedings de la 9th European Microwave Conf., 17-20 sept. 1979, pages 621-625, ou dans l'article paru dans IEEE Trans. on Microwave Theory and Techniques, vol. MTT30, n°12, décembre 1982, pages 2172-2177. Ce schéma est très simplifié et, par exemple, les tensions de polarisations n'y sont pas représentées.

Dans cet oscillateur, le transistor à effet de champ 1 est monté en grille commune: la self 4 par laquelle sa grille est mise à la masse n'est autre qu'un fil de connexion pour relier la grille, sur la pastille du transistor, à la masse du circuit, ce fil présentant une inductance d'environ 2 n H. Le circuit accordé est constitué par un varicap 2, ou diode à capacité variable, en parallèle avec une self 3, monté sur la source du transistor 1. Le varicap a une capacité moyenne de l'ordre de 0,8 pF, et la self 3 a une inductance d'environ 2 n H.

Le point délicat dans un tel oscillateur est celui de la longueur, repérée L, de la connexion entre le varicap 2 et la source du transistor 1. Sachant que les selfs 3 et 4, de 2 n H chaque, sont créées par des fils de 2 mm de longueur, la connexion de longueur L, doit être la plus courte possible, sinon la largeur de bande dans laquelle l'oscillateur a une réponse linéaire rétrécit. C'est ainsi que, pour un tel oscillateur réalisé en fixant les composants les uns à côté des autres sur un substrat, c'est-á-dire avec une longueur L de connexion importante, la linéarité en fonction de la tension de commande est limitée à 300 MHz. Pour augmenter la largeur de la bande de linéarité, on associe à l'oscillateur un circuit intégré dans lequel sont mises en mémoire plusieurs tensions de commande.

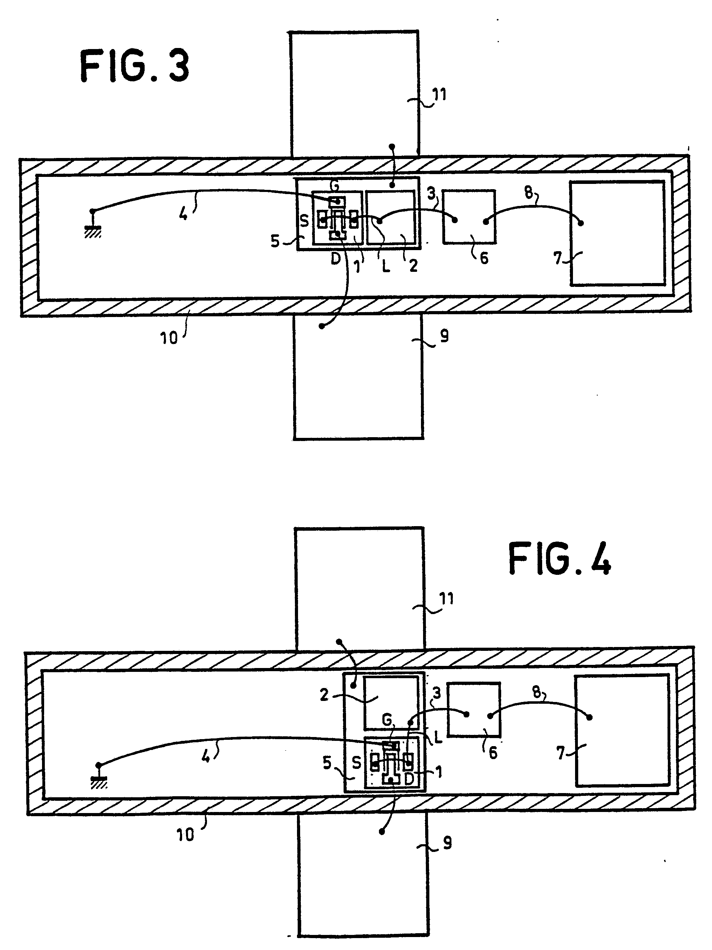

La figure 2 représente le circuit oscillant utilisé dans l'oscillateur selon l'invention: cette figure permet d'identifier les composants des figures 3 et 4.

Le schéma de base de la figure précédente se retrouve dans celui de la figure 2: le transistor à effet de champ 1 a sa grille mise à la masse par un fil qui présente une inductance 4, et un circuit accordé, constitué par un varicap 2 et une self 3 est monté sur la source du transistor 1. Une capacité 5, d'une valeur de 45 pF montée entre le varicap 2 et la masse, permet d'isoler la tension continue de polarisation $V_p$ du varicap. Appliquer la tension de polarisation $V_p$ entre le varicap 2 et la masse plutôt qu'entre le varicap 2 et la source du transistor 1 permet de supprimer une capacité de découplage entre varicap et transistor, et donc de raccourcir la longueur de connexion. Une autre capacité 6, de 45 pF également, est connectée entre l'extrémité de la self d'accord 3 et la masse: du point de vue hyperfréquences, la self 3 est quasiment à la masse. Mais cette capacité 6 découple une résistance 7, d'une valeur de 50 ohms, ajoutée pour autopolariser le transistor 1, et n'avoir qu'une seule tension d'alimentation de l'oscillateur, soit la tension de polarisation $V_p$. La self 8 représente la connexion par fil entre la capacité de découplage 6 et la résistance 7: la self 3 étant quasiment mise à la masse - en hyperfréquences - par la capacité 6, la longueur du fil et de la self 8 n'a pas grande importance pour l'oscillateur.

Le signal de sortie est recueilli sur une connexion extérieure 9, sur le drain du transistor 1. Ce drain est par ailleurs alimenté, de façon conventionnelle, par une tension $V_{DD}$ découplée par une self et une capacité à la masse. Le circuit de polarisation du drain peut être extérieur au boîtier d'encapsulation de l'oscillateur lui-même.

La figure 3 représente un premier exemple d'implantation de l'oscillateur selon l'invention.

Cet oscillateur est réalisé dans un boîtier céramique - métal rectangulaire, d'un modèle bien connu pour les transistors discrets hyperfréquences. L'embase de ce boîtier est métallique, et constitue le plan de masse. Le transistor, ou dans le cas présent l'oscillateur, est contenu dans une cavité céramique dont seul est représenté le contour interne 10. A travers les parois latérales de la cavité céramique 10 passent deux languettes métalliques qui, avec l'embase du boîtier, constituent les connexions extérieures de l'oscillateur, une première languette 11 apporte la tension de polarisation $V_p$, une seconde languette 9 constitue la sortie de l'oscillateur.

A l'intérieur de la cavité 10, qui constitue un espace de 5 x 1 mm et dont le fond est le plan de masse, est disposé, entre les deux languettes 9 et 11, un micromodule compact constitué par une pastille de capacité 5 sur laquelle sont soudées, côte à côte, une pastille de transistor 1 et une pastille de varicap 2.

La nature des pastilles fait que le varicap 2 est en contact ohmique avec la face supérieure de la capacité 5, cette face constituant une première armature de la capacité, tandis que la face inférieure de cette même capacité est en contact ohmique avec le fond du boîtier, constituant la masse. Par contre, le transistor 1 est, compte-tenu de la bande de fréquence, un transistor en matériaux III-V tel que GaAs, son substrat est semi-isolant, et l'embase de la pastille du transistor est isolée de la pastille de la capacité 5.

Les dimensions de la pastille de la capacité 5 sont plus grandes que les dimensions des deux pastilles côte à côte du transistor 1 et du varicap 2: ceci permet de thermocomprimer sur la face supérieure de la pastille de la capacité 5 un fil métallique qui, relié à la languette 11, apporte la tension de polarisation $V_p$.

Les métallisations de source, grille et drain du transistor 1 étant apparentes, un fil métallique est thermocomprimé sur le drain et sur la languette de sortie 9: la longueur de ce fil n'est pas critique. Un autre fil métallique est thermocomprimé sur la grille et sur le fond du boîtier, à la masse: il constitue la self 4, et sa longueur est calculée, soit 2 mm pour 2 n H si c'est un fil d'or de 18 μm de diamètre, d'inductance 1 n H/mm.

Un deuxième fil métallique est thermocomprimé entre la source - ou les sources si le transistor est interdigité - du transistor 1 et le varicap 2: les deux pastilles du transistor et du varicap étant côte à côte, la longueur L de ce fil, qui constitue le point sensible de l'oscillateur, est réduite au minimum, une fraction de millimètre. C'est parce que cette longueur L de fil est minimale que l'oscillateur a une réponse linéaire dans une bande trois fois plus large que les oscillateurs connus.

A côté du micromodule sont fixés sur l'embase du boîtier le circuit d'autopolarisation du transistor 1. Il est constitué par une pastille de capacité 6 et une pastille de résistance 7, réunies par un fil thermocomprimé 8. Comme en ce qui concerne le micromodule, ces pastilles 6 et 7 sont en contact ohmique avec le boîtier et elles sont donc connectées à la masse. La position de la pastille de résistance 7 et la longueur du fil de connexion 8 n'ont pas d'importance vis-à-vis de la fréquence de l'oscillateur. Par contre, la position de la pastille de capacité 6 a de l'importance, car elle règle la longueur du fil de connexion entre le varicap 2 et la capacité 6, et cette longueur constitue la self 3, d'une valeur de 1 n H, soit 1 mm. L'éloignement de la capacité 6, par rapport au varicap 2, augmente la self, et diminue la fréquence de l'oscillateur. Et réciproquement.

En figure 3, le micromodule transistor-varicap-capacité est fixé longitudinalement par rapport au boîtier. En figure 4, il est fixé transversalement, ce qui permet de raccourcir, entre autre, la connexion de sortie 9. De façon plus générale, si l'oscillateur est réalisé dans un boîtier de forme différente, il est important que le varicap 2 soit intégré à l'intérieur du boîtier, ainsi que le circuit d'autopolarisation, ce qui permet de réduire au minimum la liaison L varicap-source du transistor, pour avoir une large bande de réponse linéaire, et de régler la self 3 entre varicap et circuit d'autopolarisation, ce qui permet de régler la fréquence centrale d'oscillation.

La figure 5 représente la courbe de réponse en fréquence de l'oscillateur selon l'invention, en fonction de la tension de commande $V_p$, ainsi que la courbe de puissance en fonction de la fréquence. Ces courbes mettent en évidence la parfaite linéarité de fréquence entre 7,5 et 8,5 GHz, pour une tension de commande variant entre 7,5 et I2 V, et une bonne *stabilité de* puissance à 20 mW soit 13 dBm $\pm$ 0,3 dBm dans cette même bande de fréquence.

Bien entendu, l'oscillateur selon l'invention qui a été décrit en s'appuyant sur un cas d'oscillateur en bande X, utilisant un transistor en GaAs, et un boîtier rectangulaire, peut être realisé dans d'autres modèles de boîtiers hyperfréquences, pour d'autres bandes de fréquences, et avec des composants en d'autres matériaux et d'autres valeurs de selfs et capacités.

**Revendications**

Oscillateur hyperfréquence à transistor commandé par capacité variable de type varicap, comportant un transistor à effet de champ (1) dont la grille est mise à la masse à travers une self (4) dont le drain constitue une sortie de l'oscillateur, et dont la source est réunie à un circuit d'accord constitué par un varicap (2) en parallèle avec une self d'accord (3), le circuit oscillant comportant en outre une première capacité (5) connectée entre varicap (2) et masse en vue d'isoler de la masse la tension de commande $V_p$ appliquée au varicap (2), et, connecté entre la self d'accord (3) et la masse, un circuit d'autopolarisation formé par une résistance (7) découplée par une seconde capacité (6), cet oscillateur étant caractérisé en ce que le transistor (1), le varicap (2) et la première capacité (5) sont intégrés dans un même boîtier hyperfréquence (10), sous forme d'un micromodule, la pastille du transistor (1) et la pastille du varicap (2) étant fixées côte à côte sur la pastille de la première capacité (5), ledit boîtier étant muni de deux connexions d'accès dont la première (9) constitue la sortie de l'oscillateur et dont la deuxième (11) est alimentée par une tension de commande $V_p$.

2. Oscillateur selon la revendication 1, caractérisé en ce que la tension de commande $V_p$ du varicap (2) fournit également la tension de polarisation de la source du transistor (1), le circuit d'autopolarisation (6+7) étant intégré à l'intérieur du même boîtier (10) que le micromodule (1+2+5).

3. Oscillateur selon la revendication 1, caractérisé en ce que, la longueur (L) de liaison entre le varicap (2) et la source du transistor (1) étant minimale, la largeur de bande de fréquences est maximale, et linéaire en fonction de la tension de commande $V_p$.

4. Oscillateur selon la revendication 1, caractérisé en ce que la longueur de la connexion (3) entre le varicap (2) et la seconde capacité (6), règle la fréquence centrale de l'oscillateur, en réglant l'inductance de la self d'accord (3).

**Patentansprüche**

1. Höchstfrequenzoszillator mit einem von einer veränderlichen Kapazität vom Typ einer Kapazitätsdiode gesteuertem Transistor, einem Feldeffekttransistor (1), dessen Gate über eine Drossel (4) an Masse gelegt ist, dessen Drain einen Ausgang des Oszillators bildet und dessen Source mit einem Abstimmkreis verbunden ist, der aus einer Kapazitätsdiode (2) und einer dazu parallel geschalteten Abstimmspule (3) besteht, wobei der Schwingkreis außerdem einen ersten Kondensator (5) enthält, der zum Isolieren der Masse von der an die Kapazitätsdiode (2) angelegten Steuerspannung $V_p$ zwischen die Kapazitätsdiode (2) und Masse eingefügt ist, und ferner zwischen der Abstimmspule (3) und Masse eine Vorspannungsschaltung enthält, die von einem durch einen zweiten Kondensator (6) entkoppelten Widerstand (7) gebildet ist, dadurch gekennzeichnet, daß der Feldeffekttransistor (1), die Kapazitätsdiode (2) und der erste Kondensator (5) im gleichen Höchstfrequenzgehäuse (10) in Form eines Mikromoduls integriert sind, wobei das Plättchen des Transistors (1) und das Plättchen der Kapazitätsdiode (2) Seite an Seite auf dem Plättchen des ersten Kondensators (5) befestigt sind und wobei das Gehäuse mit zwei Zugangsanschlüssen versehen ist, von denen der erste (9) den Ausgang des Oszillators bildet, während der zweite (11) mit der Steuerspannung $V_p$ gespeist ist.

2. Oszillator nach Anspruch 1, dadurch gekennzeichnet, daß die Steuerspannung $V_p$ der Kapazitätsdiode (2) auch die Vorspannung für die Source des Feldeffekttransistors (1) liefert, wobei die Vorspannungsschaltung (6+7) im Inneren des gleichen Gehäuses (10) integriert ist, in dem sich auch das Mikromodul (1+2+5) befindet.

3. Oszillator nach Anspruch 1, dadurch gekennzeichnet, daß die Länge (L) der Verbindung zwischen der Kapazitätsdiode (2) und der Source des Feldeffekttransistors (1) minimal ist, daß die Breite der Frequenzbänder maximal und linear abhängig von der Steuerspannung $V_p$ ist.

4. Oszillator nach Anspruch 1, dadurch gekennzeichnet, daß die Länge der Verbindung (3) zwischen den Kapazitätsdiode (2) und dem zweiten Kondensator (6) die Mittenfrequenz des Oszillators regelt, indem die Induktivität der Abstimmspule (3) geregelt wird.

**Claims**

1. Super high frequency oscillator comprising a transistor controlled by a variable capacitance of varicap type, a field-effect transistor (1) whose gate is applied via a choke (4) to ground, whose drain forms and output of the oscillator and whose source is connected to a tuning circuit formed by a varicap (2) and a tuning coil (3) connected in parallel thereto, the oscillating circuit further including a first capacitor (5) connected between the varicap (2) and ground for isolating ground from the control voltage $V_p$ applied to the varicap (2), and furthermore between the tuning coil (3) and ground includes a bias circuit formed by a resistor (7) decoupled by a second capacitor (6), characterized in that the field-effect transistor (1), the varicap (2) and the first capacitor (5) are integrated in the same super high frequency housing (10) in the form of a micromodule, the wafer of the transistor (1) and the wafer of the varicap (2) being mounted side by side on the wafer of the first capacitor (5) and the housing being provided with two access connections, the first (9) of which forms the output of the oscillator whilst the second (11) is fed with the control voltage $V_p$.

2. Oscillator according to claim 1, characterized in that the control voltage $V_p$ of the varicap (2) also furnishes the bias for the source of the field-effect transistor (1), the bias circuit (6+7) being integrated in the interior of the same housing (10) as the micromodule (1+2+5).

3. Oscillator according to claim 1, characterized in that the length (L) of the connection between the varicap (2) and the source of the field-effect transistor (1) is a minimum and the width of the frequency bands is a maximum and linearly dependent on the control voltage $V_p$.

4. Oscillator according to claim 1, characterized in that the length of the connection (3) between the varicap (2) and the second capacitor (6) controls the centre frequency of the oscillator by regulating the inductance of the tuning coil (3).

0 156 708

FIG.1

PRIOR ART

FIG.2

FIG.5

1

# FIG. 3

# FIG. 4